# EUROPEAN PATENT SPECIFICATION

(11) **EP 3 462 489 B1**
(45) Date of publication and mention of the grant of the patent: **26.05.2021**
(21) Application number: 18196612.8
(22) Date of filing: 25.09.2018
(51) Int. Cl.: H01L 25/075, H01L 33/20, H01L 33/42, H01L 33/62, H01L 33/00

(54) **MESA SHAPED MICRO LIGHT EMITTING DIODE WITH BOTTOM N-CONTACT**
MESAFÖRMIGE MIKRO-LEUCHTDIODE MIT UNTEREM N-KONTAKT
MICRO-DIODE ÉLECTROLUMINESCENTE DE FORME MÉSA À CONTACT N INFÉRIEUR

(30) Priority: 29.09.2017 US 201715721417; 07.09.2018 WO PCT/US2018/049962
(43) Date of publication of application: 03.04.2019
(73) Proprietor: Facebook Technologies, LLC, Menlo Park, CA 94025 (US)
(72) Inventor: OYER, Celine Claire, Menlo Park, CA California 94025 (US)
(74) Representative: Murgitroyd & Company

(56) References cited:
- EP-A2- 1 821 347
- CN-A- 105 336 734
- JP-A- H0 818 105
- US-A1- 2008 224 153
- US-A1- 2016 155 913
- US-B1- 6 410 942

## Description

### BACKGROUND

This disclosure relates to a mesa shaped micro light emitting diode (LED) with the N-contact pad at the base of a mesa.

LEDs convert electrical energy into optical energy. In semiconductor LEDs, light is usually generated through recombination of electrons, originating from an n-type doped semiconductor layer, and holes originating from a p-type doped semiconductor layer. As used herein, the term "light" includes not just visible light, but also electromagnetic radiation having a wavelength outside that of the visible range, including infrared and ultraviolet radiation.

Prior bottom-emitting micro-LEDs ("µLEDs") have a p-contact and an n-contact both formed on the top side of the µLED. In some cases, the p-contact is formed on top of a mesa structure that includes a p-type layer, a quantum well, and an n-type layer. The n-type layer extends beyond the mesa structure, and the n-contact is formed on top of this extended portion of the n-type layer. A transistor layer, such as a thin film transistor (TFT) layer, connects to the p-contact and the n-contact. The transistors apply a voltage difference between the n-contact and the p-contact which causes current to flow between the contacts and light to emit from the quantum well. The light is emitted through the bottom side of the µLED, opposite the electrical contacts and the transistor layer.

In this configuration, light emits only from the mesa structure, which is underneath the p-contact. No light emits from the area underneath the n-contact. It would be desirable to increase the amount of light extracted relative to the area of the µLED, and to increase the density of µLEDs in arrangements with multiple µLED devices. In addition, it is desirable to simplify the process of producing µLEDs to reduce cost and time of production.

US 6,410,942 B1 discloses a LED structure. The LED structure includes arrays of electrically interconnected µLED arrays. The µLED structured has an active layer sandwiched between two oppositely doped layers. The µLED has angled side surfaces. The µLED array is formed on a first spreader layer. On each µLED a hole is included in an insulating layer covering the µLED and the surface of the first spreader between adjacent µLEDs, for a top contact. A second spreader layer coats the entire µLED array to interconnect the top contacts. Light from the LED is primarily emitted through the substrate.

EP 1 821 347 A2 discloses a manufacturing method for a LED. The GaN semiconductor layer has a multilayer structure and a first electrode are formed over a sapphire substrate. The semiconductor layer is grown, using, for example, a general semiconductor growing method. For the semiconductor growing method, various methods, for example, PVD such as sputtering, MOCVD using organic metal pre-cursor, and ion implanting, may be selectively used in accordance with the convenience of the process. The semiconductor layer includes an n type semiconductor layer, an active layer, and a p type semiconductor layer. The semiconductor layer has a structure having an area which gradually reduces with distance from the substrate.

JP H0818105 A discloses a relationship between an average height of LED chips and an average height of solder bumps on the light pick up electrodes of the LED chips.

CN 105 336 734 A discloses an vertical packaging structure for LEDs. The LED vertical packaging structure comprises a vertical LED chip, a first substrate, a second substrate, a first electrode and a second electrode, and also includes a first conducting layer and a second conducting layer, wherein the vertical LED chip is arranged between the first substrate and the second substrate; the first conducting layer is arranged on the first substrate, and is electrically connected with the first electrode; the second conducting layer is arranged on the second substrate and is electrically connected with the second electrode; the vertical LED chip is provided with a top electrode and a bottom electrode; the top electrode is electrically connected with the first conducting layer; and the bottom electrode is electrically connected with the second conducting layer.

US 2016/155913 A1 discloses a light emitting device including first and second light transmissive insulators and a light emitting diode arranged between them. First and second electrodes of the light emitting diode are electrically connected to a conductive circuit layer provided on a surface of at least one of the first and second light transmissive insulators.

US 2008/224153 A1 discloses an electronic device including a base having a first wiring thereon; a flexible film having a second wiring thereon; a plurality of elements each including a first connecting portion and a second connecting portion; and an adhesive agent layer, wherein each of the elements is sandwiched between the base and the film in a state in which the first connecting portion is in contact with the first wiring, the second connecting portion is in contact with the second wiring, and a tensile force is applied to the film, and, in this state, the base and the film are bonded with the adhesive agent layer.

### SUMMARY

According to the invention there is provided a method for fabricating a light emitting diode in accordance with claim 1, a light emitting diode (LED) assembly in accordance with claim 8, and a light emitting diode (LED) assembly wafer in accordance with claim 14.

In some embodiments, the second electrical contact is a transparent conductive oxide material. The second electrical contact may be formed by depositing the transparent conductive oxide material as a thin film on the bottom of the semiconductor structure.

In some embodiments, the semiconductor structure is aligned to a first circuitry substrate and the first electrical contact is connected to a contact pad on the first circuitry substrate. The semiconductor structure is also aligned to a second circuitry substrate and is connected via the second electrical contact to another contact pad on the second circuitry substrate. The second circuitry substrate may be transparent.

In some embodiments, the formed layers of material are shaped by etching the layers of materials into a mesa. In some embodiments, the layers of material are etched through during the shaping of the formed layers to individuate the at least one semiconductor structure.

The first semiconductor layer may have a first electrical resistivity along a direction of height and a second electrical resistivity in a direction perpendicular to the direction of height. The first electrical resistivity lower than the second electrical resistivity.

Embodiments also relate to LED including a semiconductor structure having a first semiconductor layer, a second semiconductor layer, and a light emitting layer between the first semiconductor layer and the second semiconductor layer for producing light responsive to passing current through the light emitting layer. The LED also includes a first electrical contact on a top surface of the semiconductor structure, and a second electrical contact on a bottom surface of the semiconductor structure. The second electrical contact may be at least partially transparent. The bottom of the semiconductor structure may have a circular shape.

In other aspects, an LED assembly wafer is disclosed herein. The LED assembly wafer includes a plurality of the LEDs described above, along with a first substrate having first contacts pads each connected to a respective one of the first electrical contacts of the plurality of LEDs, and a second substrate having second contact pads each connected to a respective one of the second electrical contacts of the plurality of LEDs.

According to the invention, there is provided a method for fabricating a light emitting diode (LED) in accordance with claim 1.

In an embodiment according to the invention, a method may comprise:
aligning the semiconductor structure to a first circuitry substrate;
connecting the first electrical contact to a contact pad on the first circuitry substrate;
aligning the semiconductor structure to a second circuitry substrate; and
connecting the second electrical contact to another contact pad on the second circuitry substrate.

In an embodiment according to the invention, a method may comprise:
aligning the semiconductor structure to the first circuitry substrate; and
aligning the semiconductor structure to the second circuitry substrate.

The second circuitry substrate may be transparent.

Forming the first electrical contact on top of the semiconductor structure comprises forming the first electrical contact on the first circuitry substrate; and
bonding the first electrical contact on the first circuitry substrate to the top of the semiconductor structure to form the first electrical contact on top of the semiconductor structure.

Forming the second electrical contact at the bottom of the semiconductor structure may comprise:
forming the second first electrical contact on the second circuitry substrate; and
bonding the second electrical contact on the second circuitry substrate to the bottom of the semiconductor structure to form the second electrical contact at the bottom of the semiconductor structure.

The second electrical contact may comprise a transparent conductive oxide material.

Forming the second electrical contact at the bottom of the semiconductor structure may comprise depositing the transparent conductive oxide material as a thin film on the bottom of the semiconductor structure.

Shaping the formed layers of material may comprise etching the layers of materials into a mesa, the first electrical contact formed on a top of the mesa.

The layers of material may be etched through during the shaping of the formed layers to individuate the at least one semiconductor structure.

The first semiconductor layer may have a first electrical resistivity along a direction of height and a second electrical resistivity in a direction perpendicular to the direction of height, the first electrical resistivity lower than the second electrical resistivity.

In an embodiment according to the invention, a light emitting diode (LED) assembly is provided in accordance with claim 8.

The semiconductor structure may have a mesa shape.

The second electrical contact may extend across the bottom surface of the semiconductor structure.

The second electrical contact may be a transparent thin film conducting oxide.

The first electrical contact may be made of non-transparent metal.

The first semiconductor layer may have a first electrical resistivity along a direction of height and a second electrical resistivity in a direction perpendicular to the direction of height, the first electrical resistivity lower than the second electrical resistivity.

The bottom of the semiconductor structure may have a circular shape.

In an embodiment according to the invention, a light emitting diode (LED) assembly wafer is provided in accordance with claim 14.

In an embodiment according to the invention, one or more computer-readable non-transitory storage media may embody software that is operable when executed to perform a method according to the invention or any of the above mentioned embodiments.

In an embodiment according to the invention, a system within a fabrication system may comprise: one or more processors; and at least one memory coupled to the processors and comprising instructions executable by the processors, the processors operable when executing the instructions to perform a method according to the invention or any of the above mentioned embodiments.

In an embodiment according to the invention, a computer program product, preferably comprising a computer-readable non-transitory storage media, may be operable when executed on a data processing system within a fabrication system to perform a method according to the invention or any of the above mentioned embodiments.

### BRIEF DESCRIPTION OF DRAWINGS

- FIG. 1: is a cross sectional diagram of a µLED with a mesa shaped structure.
- FIG. 2: is a cross sectional diagram of a µLED with electrical contacts at the top and bottom of the structure, according to one embodiment.
- FIG. 3: is a cross sectional diagram of the µLED of FIG. 2 arranged between two circuitry substrates, according to one embodiment.
- FIG. 4: is a top view of an assembly of the µLEDs of FIG. 2, according to one embodiment.
- FIG. 5: is a flowchart illustrating the process for generating an assembly of µLEDs with top and bottom electrical contacts, according to one embodiment.
- FIG. 6: is a flowchart illustrating another process for generating an assembly of µLEDs with top and bottom electrical contacts, according to one embodiment.

### DETAILED DESCRIPTION

Embodiments relate to a mesa-shaped bottom-emitting micro LED, or "µLED," that has an n-contact at the bottom of the µLED structure. Relative to prior µLEDs, the disclosed µLED structure increases the amount of light extracted relative to size of the µLED, and increases the density of µLEDs in arrangements with multiple µLED devices. These benefits are achieved by moving the n-contact from the side of a light-emitting semiconductor structure, where it is typically placed on bottom-emitting µLEDs, to the bottom of the semiconductor structure, so that layers of semiconductor material and a quantum well are sandwiched between a p-contact on the top of the semiconductor structure and an n-contact on the bottom of the semiconductor structure. Embodiments also relate to a process of producing these µLEDs that reduces cost and time of production compared to prior µLED production methods.

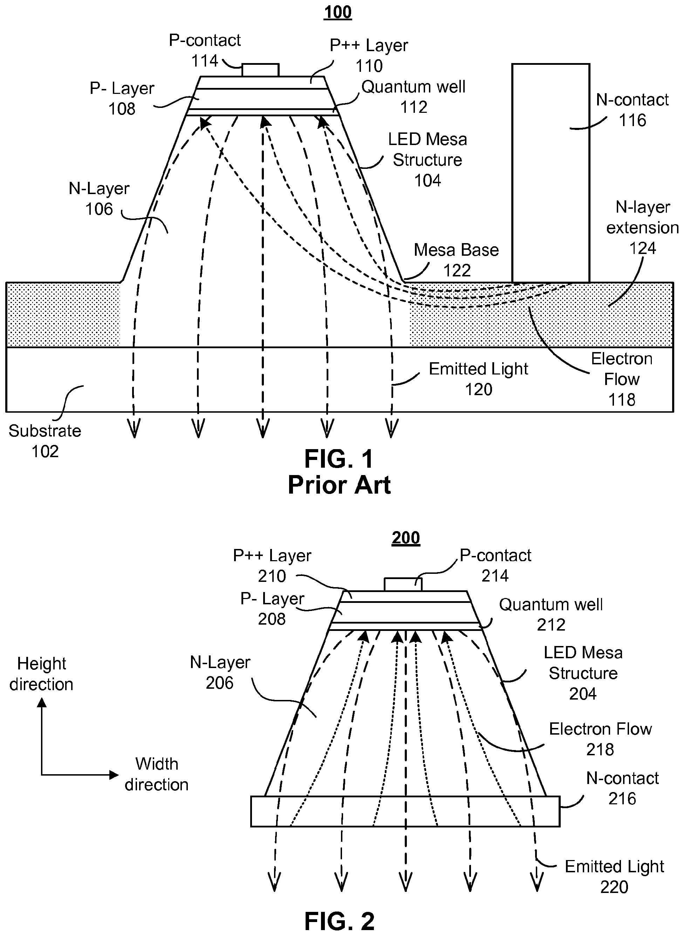

FIG. 1 is a cross sectional diagram of a conventional bottom-emitting mesa shaped µLED 100. A µLED, or "Micro LED," refers to a particular type of LED having a small active light emitting area (e.g., less than 2,000 µm²). Bottom-emitting µLEDs emit light through a bottom surface of the µLED. The bottom surface typically has an emitting area, which refers herein to an area of the bottom surface through light is emitted during operation of the µLED, and a non-emitting area, which refers herein to an area of the bottom surface through which light is not emitted during operation of the µLED.

During manufacture, the µLED 100 is formed on a substrate 102, such as a sapphire substrate. An LED mesa structure 104 is formed above the substrate 102. The LED mesa structure 104 is made up of several semiconductor layers: an n-layer 106, a p-layer 108, and a p++ layer 110. The n-layer 106 is an n-type semiconductor, such as n-type gallium nitride ("N-GaN"), and the p-layer 108 and p++ layer 110 are a p-type semiconductor, such as p-type gallium nitride ("P-GaN" and "P++ GaN"). The p++ layer 110 has a higher doping concentration than the p-layer 108. In some embodiments, only one p-type layer with a single concentration is used instead of both a p-layer 108 and a p++ layer 110. A quantum well 112 is formed between the p-layer 108 and the n-layer 106. The quantum well emits light when excited by a current.

As shown in FIG. 1, the semiconductor layers 106, 108, and 110 and the quantum well 112 are formed into a semi-parabolic mesa shape 104. The mesa structure 104 has a mesa base 122, which may be circular. The n-type layer 106 extends below the mesa base 122 and around the diameter of the mesa base 122. The extension of the n-layer 106 beyond the diameter of the mesa base 122 is shown as the shaded n-layer extension region 124 in FIG. 1.

A p-contact 114 is formed on the top of the mesa, connecting to the p++ layer 110. An n-contact 116 is formed on the n-layer extension 124 of the n-layer 106. Contact pads can be applied to both the n-contact 116 and the p-contact 114 to connect the µLED 100 to a transistor layer, such as a thin film transistor (TFT) layer (not shown). In addition, the µLED 100 can be removed from the substrate 102 and placed on a transparent layer, such as glass.

During operation of the µLED 100, a voltage difference is applied between the n-contact 116 and the p-contact 114 so that electrons flow from the n-contact 116 towards the p-contact 114. The arrows 118 show the path of the electron flow along the n-layer extension 124 of the n-layer 106 towards the mesa structure 104, and up through the mesa structure 104 to the quantum well 112. Light is emitted from the quantum well 112 and through the n-type semiconductor 106 and the transparent layer. The arrows 120 show the direction of the emitted light.

The mesa structure 104 has a truncated top, on a side opposed to a light transmitting or emitting face of the µLED 100. The mesa 104 has a near-parabolic shape to form a reflective enclosure for light generated within the µLED 100. When the light emitted from the quantum well 112 reflects off of the walls of the mesa structure 104 and/or the p-contact 114, the µLED 100 outputs collimated or quasi-collimated light that has a reduced beam angle compared to light emitted from a standard unfocused LED device. Collimating the light is beneficial because it increases the brightness level of light emitted from the small active light emitting area and prevents the spreading of emitted light into the beampath of other adjacent µLEDs or photodetectors.

As shown in FIG. 1, light is only emitted in the region under the LED mesa structure 104. No light is emitted in the area of the n-layer extension 124, on which the n-contact 116 is formed. When multiple µLEDs 100 are positioned together, the amount of light extracted relative to the size of the bottom surface of the µLEDs 100, and the density of the light-emitting portions of the µLEDs 100, is limited by size of the non-emitting area used for the n-contacts 116 of the µLEDs 100. In addition, the electron flow 118 encounters resistance between the n-contact 116 and the quantum well 112. A lower resistance within the device would improve the operation of the µLED 100.

FIG. 2 is a cross sectional diagram of a µLED 200 with electrical contacts at the top and bottom of the structure, according to one embodiment. The n-contact in the µLED 200 is at the bottom of the LED mesa structure, rather than to the side of the LED mesa structure, thus eliminating the need to have the n-layer extend beyond the diameter of the mesa structure for forming the n-contact.

The µLED 200 includes an LED mesa structure 204, a p-contact 214 disposed on the top of the LED mesa structure 204, and an n-contact 216 disposed on the bottom of the LED mesa structure 204. The LED mesa structure 204 may include, among other components, an n-layer 206, a p-layer 208, a p++ layer 210, and a quantum well 212. The quantum well 212 emits light when a voltage difference is applied between the p-contact 214 and the n-contact 216, causing a current to pass through the LED mesa structure 204. The arrows 218 show the path of the electron flow from the n-layer 206 to the quantum well 212.

Light is emitted from the quantum well 212 and through the n-layer 206. The arrows 220 show the direction of the emitted light. The elements of the LED mesa structure 204 (i.e., the n-layer 206, the p-layer 208, the p++ layer 210, and the quantum well 212) and the p-contact 214 are similar to the corresponding elements of the LED mesa structure 104 and the p-contact 114 described with respect to FIG. 1. In addition, the LED mesa structure 204 has a similar semi-parabolic shape to the LED mesa structure 104 described with respect to FIG. 1, and the µLED 200 outputs collimated or quasi-collimated light. The base of the LED mesa structure 204 may be circular or oblong. In some embodiments, the LED mesa structure 204 is formed by growing the layers in order from the n-layer 206. In such embodiments, the n-layer 206 is grown first, followed by a quantum well layer 212, the p-layer 208, and the p++ layer 210. The p++ layer 210 is optional, and in some embodiments, additional layers are included, such as an electron blocking layer or a strain release layer. After the layers are grown, the mesa structure 204 is etched.

The n-contact 216 of the µLED 200 is formed directly on the LED mesa structure 204, at the bottom of the mesa. The n-contact 216 is transparent or semitransparent so that the emitted light 220 can pass through the n-contact 216. For example, the n-contact 216 can be a transparent conductive oxide material that is deposited as a thin film on the bottom of the LED mesa structure 204. Because the n-contact 216 is formed directly on the LED mesa structure 204, the n-layer 206 does not need to extend beyond the diameter of the base of the LED mesa structure 204. Instead, the layers of material in the LED mesa structure 204, including the n-layer 206, are etched all the way through during the shaping of the LED mesa structure 204. This individuates the mesa structure 204 from neighboring mesa structures formed on the same substrate.

Forming the n-contact 216 on the bottom of the LED mesa structure 204 and removing the n-layer extension reduces the size of the bottom surface of the µLED 200 compared to the µLED 100 in FIG. 1. The area of the top and bottom of the n-contact 216 may be the same as the area of the base of the LED mesa structure 204. In other embodiments, the top and bottom area of the n-contact 216 may be somewhat larger than the area of the base of the LED mesa structure 204 (as shown in FIG. 2), or the top and bottom area of the n-contact 216 may be smaller than the area of the base of the LED mesa structure 204 (e.g., the n-contact 216 may only cover a portion of the base of the LED mesa structure 204).

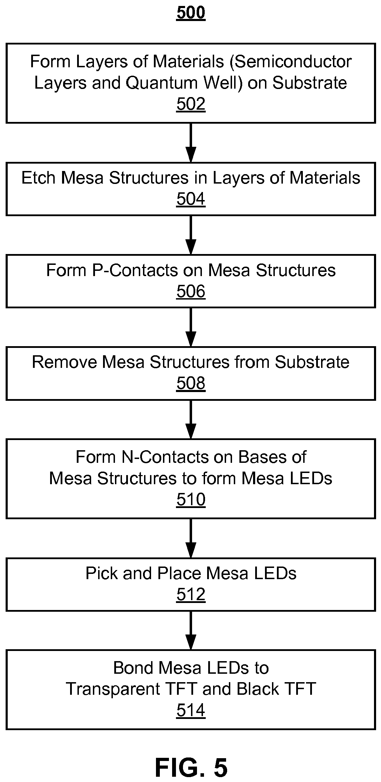

The LED mesa structure 204 is constructed from one or more semiconductor materials, which may include gallium nitride, indium gallium nitride, aluminum gallium phosphide, gallium arsenide, gallium arsenide phosphide, zinc selenide, or any combination of these materials such that a transparent light emitting semiconductor is formed. The LED mesa structure 204 and the p-contact 214 may be initially formed on an epi-wafer or other substrate, which may substantially include one or more of sapphire, gallium nitride, aluminum nitride, gallium arsenide, indium phosphide, gallium phosphide and/or silicon carbide. As described above, the LED mesa structure 204 can be formed growing the layers in order, i.e., by growing the n-layer 206 first, followed by the quantum well layer 212, the p-layer 208, and the p++ layer 210. After the layers are grown, the mesa structure 204 is etched and the p-contact 214 is formed on top of the mesa 204. After the LED mesa structure 204 and the p-contact 214 are formed, the substrate is removed, and the n-contact 216 is formed on the base of the LED mesa structure 204. A method for producing the µLED 200 is described in greater detail with respect to FIG. 5.

In addition to the reduced size of the µLED 200, another advantage to the configuration of the µLED 200 over the µLED 100 is that the resistance between the n-contact 216 and the quantum well 212 (i.e., the resistance in the n-layer 216) of FIG. 2 is less than the resistance between the n-contact 116 and the quantum well 112 (i.e., the resistance in the n-layer 116) of FIG. 1. There are several reasons that the resistance in the n-layer 206 is lower. First, etching the LED mesa structure 104 in the µLED 100 makes the surface of the LED mesa structure 104 near the mesa base 122 rough, which increases the resistivity in the area around the mesa base 122. As shown in FIG. 1, the electron flow 118 travels through this rough, high resistivity area. In FIG. 2, the electron flow 218 travels directly up from the n-contact 216, and most of the electron flow 218 is not close to the edge of the mesa 204. Thus, most of the electron flow 218 is not affected by a high resistance near the mesa base, resulting in a lower resistance in the µLED 200 than in the µLED 100.

Second, the resistivity of the n-type material may vary based on the direction of electron flow. A reference height direction and width direction are shown in FIG. 2. In some semiconductor materials, the electrical resistivity in the height direction is higher than the resistivity in the width direction. Thus, the electron flow 118 in FIG. 1 has high resistance when it moves through the n-layer extension 124 between the n-contact 116 and the LED mesa structure 104. By contrast, the electron flow 218 moves primarily in the lower-resistivity height direction, resulting in an overall lower resistance in the µLED 200 than the µLED 100.

Third, even in the case that the resistivity of the n-layer 106 is the same as the resistivity of the n-layer 206, the distance that the electrons travel between the n-contact 116 and the quantum well 112 in µLED 100 is longer than the distance that the electrons travel between the n-contact 216 and the quantum well 212 in µLED 200, which makes the resistance of the n-layer 106 greater than the resistance of the n-layer 206.

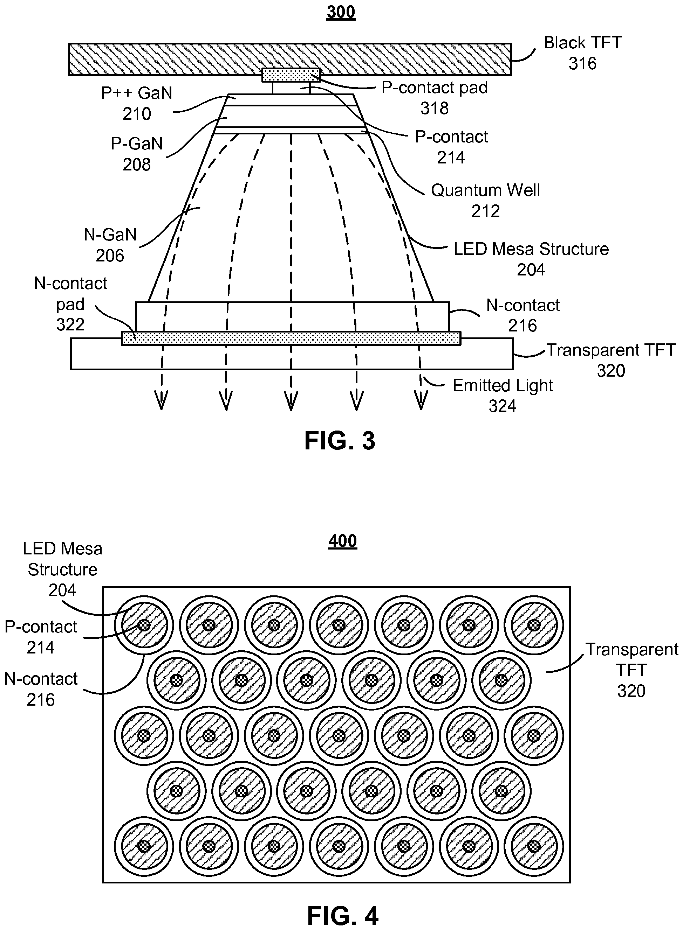

FIG. 3 is a cross sectional diagram 300 showing the µLED of FIG. 2 arranged between and connected to two circuitry substrates, according to one embodiment. The µLED shown in FIG. 3 has the same components as the µLED 200 in FIG. 2. In particular, FIG. 3 shows the LED mesa structure 204, the p-contact 214 disposed on the top of the LED mesa structure 204, and the n-contact 216 disposed on the bottom of the LED mesa structure 204. The LED mesa structure 204 may include, among other components, the n-layer 206, the p-layer 208, the p++ layer 210, and the quantum well 212. As mentioned above, the p++ layer 210 is optional, and other layers may be included.

FIG. 3 shows the µLED 200 attached to circuitry substrates, which are used to apply voltages to the n-contact 216 and the p-contact 214. The top circuitry substrate is a black thin film transistor (TFT) 316. The bottom circuity substrate is a transparent TFT 320. TFTs are made by depositing thin films of an active semiconductor layer along with a dielectric layer and metallic contacts over a supporting non-conducting substrate, such as glass. TFT 316 and TFT 320 may include transistors based on amorphous silicon (A -Si), low temperature polysilicon (LTPS), or amorphous Indium Gallium Zinc Oxide (IGZO) technology, among others. The substrate sizes may range from first generation displays of around 30 cm x 40 cm to larger displays, such as tenth generation displays (known as GEN 10) of around 2.88 m x 3.15 m, GEN 10.5 displays of around 2.94 m x 3.37 m, or larger display sizes. In some embodiments, instead of the TFT 316, TFT 320, or both TFTs 316 and 320, a back-plane may be used to connect the electrical contact to a current source.

The p-contact 214 of the µLED 200 is attached to the black TFT 316 via a p-contact pad 318. The n-contact 216 of the µLED 200 is attached to the transparent TFT 320 via an n-contact pad 322. The contact pads 318 and 322 are made of a conductive material. The contact pads 318 and 322 may be formed on the µLED 200, or the contact pads 318 and 322 may be formed on their respective TFTs 316 and 320. A bonding element may be used to connect the contact pads 318 and 322 to the respective TFTs 316 and 320.

In prior µLED assemblies, such as an assembly of the µLEDs 100 in FIG. 1, the density at which the µLEDs could be arranged was limited not only by the prior arrangement of the n-contact next to the mesa, but also by the density of transistors in the TFT layer. In such prior assemblies, each µLED needed two transistors in the TFT layer-one for the n-contact 116, and one for the p-contact 114. By contrast, an assembly of the µLEDs 200 has two TFT layers-one below the n-contacts 216, and one above the p-contacts 214-and each TFT layer only includes transistor per µLED 200. Because half as many transistors are needed on the TFT layer, the µLEDs 200 can be placed with higher density.

FIG. 4 is a top view of an assembly 400 of the µLEDs of FIG. 2, according to one embodiment. The assembly shows an arrangement of multiple µLEDs 200 arranged on the transparent TFT 320. The p-contact 214, LED mesa structure 204, and n-contact 216 of each µLED 200 are shown. The LED mesa structures 204 are shaded with diagonal lines, and the p-contacts 216 are shaded in a checkerboard pattern. P-contact pads 318 and the black TFT 316 (not shown) would be arranged on top of the assembly 400. The µLEDs 200 in assembly 400 are packed close together, with little distance between the µLEDs. This results in a dense display with a high emission. An assembled wafer can be fully populated, without losing space on the wafer to non-emitting areas for n-contacts.

FIG. 5 is a process 500 for generating an assembly of µLEDs with top and bottom electrical contacts, according to one embodiment.

Layers of semiconductor material and a quantum well are formed 502 on a substrate. For example, the layers may include an n-layer 206, a p-layer 208, a p++ layer 210, and a quantum well 212 between the n-layer 206 and the p-layer 208. In some embodiments, there is a single p-layer rather than both a p-layer 208 and a p++ layer 210. The semiconductor layers may include one or more of gallium nitride, indium gallium nitride, aluminum gallium phosphide, gallium arsenide, gallium arsenide phosphide, zinc selenide, or any combination of these materials such that a transparent light emitting semiconductor is formed. The substrate may substantially include one or more of sapphire, gallium nitride, aluminum nitride, gallium arsenide, indium phosphide, gallium phosphide and/or silicon carbide.

The layers of materials on the substrate are etched 504 into mesa structures. The etching may be performed using standard LED fabrication techniques. The layers of material may be etched through to the substrate. If multiple mesa structures are etched into the layers of materials, etching the layers through to the substrate individuates each mesa.

In the embodiments of the invention the p-contacts are not formed 506 on the mesa structure, and instead are deposited on the black TFT and applied to the tops of the mesas when the mesa structures are placed onto the TFTs.

The mesa structures with the p-contacts are removed 508 from the substrate. For example, a laser lift-off (LLO) process can be applied to the GaN mesa structures to remove them from a sapphire substrate. LLO involves removing the substrate using a laser beam, such as an ultraviolet (UV) beam. The laser beam is directed through the substrate to the n-layer of the mesa structure, which causes the mesa structure to separate from the substrate. Other processes can be used to remove the mesa structure from the substrate, depending on the materials used; for example, an etch stop layer (ESL) can be deposited onto a substrate to separate the substrate from the mesa structure. In other embodiments, wet etching, dry etching, mechanical release, or thermal release techniques can be used to remove the mesa structure from the substrate.

In some embodiments, any or all of steps 502, 504, 506, and 508 are performed according to the techniques for forming a mesa-shaped µLED described in U.S. Patent No. 7,598,149.

N-contacts are formed 510 on the bases of the mesa structures, forming mesa LEDs. The n-contacts may be a made of a transparent oxide material that is deposited to the bottom of the mesa structures as a thin film. In some embodiments, the n-contacts are formed on the transparent TFT, and applied to the bases of the mesa structures when the mesa structures are placed onto the transparent TFT.

The mesa LEDs are picked and placed 512 onto the transparent and black TFTs. In particular, the p-contacts on the mesa LEDs can be aligned with the contact pads on the black TFT, and the n-contacts on the mesa LEDs can be aligned with the contact pads on the transparent TFT.

The mesa LEDs are bonded 514 to the transparent and black TFTs, e.g., using thermocompression bonding.

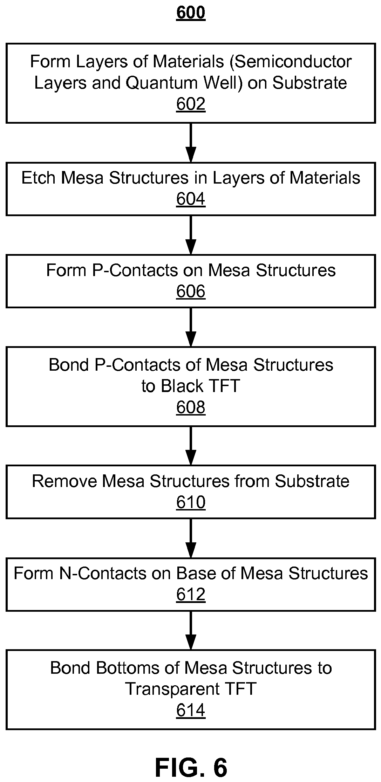

FIG. 6 is a process 600 for generating an assembly of µLEDs with top and bottom electrical contacts, according to another embodiment.

Layers of semiconductor material and a quantum well are formed 602 on a substrate. The layers of semiconductor material and quantum well may be formed 602 according to techniques described above in reference to the forming 502 in FIG. 5.

The layers of materials on the substrate are etched 604 into mesa structures, in a manner similar to the etching 504 described above in reference to FIG. 5.

P-contacts are formed 606 on the mesa structures in a manner similar to the p-contact formation 506 described above in reference to FIG. 5.

The p-contacts of the mesa structures are then bonded 608 to the black TFT, while the mesa structures are still attached to the substrate. In some embodiments, rather than forming 606 the p-contacts on the mesa structures, the p-contacts are formed on the black TFT and attached to the mesa structures during the bonding 608.

After the mesa structures are bonded to the black TFT, the mesa structures are removed 610 from the substrate. For example, laser lift-off, wet etching, dry etching, an etch stop layer, mechanical release, or thermal release techniques can be used to remove the mesa structure from the substrate.

N-contacts are formed 612 on the bases of the mesa structures. The n-contacts may be a made of a transparent oxide material that is deposited to the bottom of the mesa structures as a thin film. In some embodiments, the n-contacts are formed on the transparent TFT instead of the mesa structures.

The bottoms of the mesa structures are bonded 614 onto the transparent TFT. If the n-contacts were formed 612 on the bases of the mesa structures, the n-contacts can be aligned with the contact pads on the transparent TFT and bonded using, e.g., thermocompression bonding. Alternatively, if the n-contacts were formed on the transparent TFT, the bases of the mesa structures are bonded to the n-contacts on the transparent TFT, both forming the n-contact on the base of the mesa structure and bonding the mesa structures to the transparent TFT. In some embodiments, the metal bond pads on the transparent TFT create the n-contact when bonded to the mesa structures.

While the above embodiments were described with reference to a µLED having a p-contact at the top, a p-type region below the p-contact, an n-type region below the p-contact, and an n-contact at the bottom of the µLED, it should be understood that the polarity of the p-region and the n-region can be reversed, such that the upper portion of the mesa is an n-type material, and the lower portion of the mesa is a p-type material. In such embodiments, the top contact of the µLED is an n-contact, and the bottom contact of the µLED is a p-contact.

## Claims

1. A method for fabricating a light emitting diode (LED), the method comprising:
forming (502, 602) layers of materials on a substrate, the layers of materials including a first semiconductor layer (206), a second semiconductor layer (208), and a light emitting layer (212) between the first and second semiconductor layers (206, 208) for producing light responsive to passing current through the light emitting layer (212);
shaping (504, 604) the formed layers of material into at least one semiconductor structure (204);
forming (506, 606) a first electrical contact (214) on a first circuitry substrate (316) and bonding the first electrical contact (214) on the first circuitry substrate (316) to a top of the semiconductor structure (204) to form the first electrical contact (214) on top of the semiconductor structure (204);
removing (508, 610) the semiconductor structure (204) from the substrate;
forming (510, 612) a second electrical contact (216) at a bottom of the semiconductor structure (204), wherein the second electrical contact (216) is at least partially transparent;
the first electrical contact (214) being connected to a contact pad (318) on the first circuitry substrate (316); and
connecting (514, 614) the second electrical contact (216) to another contact pad (322) on a second circuitry substrate (320).

2. The method of claim 1, further comprising:
aligning the semiconductor structure (204) to the first circuitry substrate (316); and
aligning the semiconductor structure (204) to the second circuitry substrate (320).

3. The method of claim 1 or 2, wherein the second circuitry substrate (320) is transparent.

4. The method of any of claims 1 to 3, wherein forming (510, 612) the second electrical contact (216) at the bottom of the semiconductor structure (204) comprises:
forming the second electrical contact on the second circuitry substrate (320); and
bonding the second electrical contact on the second circuitry substrate (320) to the bottom of the semiconductor structure (204) to form the second electrical contact (216) at the bottom of the semiconductor structure (204).

5. The method of any of claims 1 to 4, wherein the second electrical contact (216) comprises a transparent conductive oxide material;
optionally, wherein forming (510, 612) the second electrical contact (216) at the bottom of the semiconductor structure (204) comprises depositing the transparent conductive oxide material as a thin film on the bottom of the semiconductor structure (204).

6. The method of any of claims 1 to 5, wherein shaping (504, 604) the formed layers of material comprises etching the layers of materials into a mesa (204), the first electrical contact (214) formed on a top of the mesa (204); optionally, wherein the layers of material are etched through during the shaping (504, 604) of the formed layers to individuate the at least one semiconductor structure (204).

7. The method of any of claims 1 to 6, wherein the electrical resistivity of the material forming the first semiconductor layer (206) varies based on the direction of electron flow (218), wherein the first semiconductor layer (206) has a first electrical resistivity along a direction of height and a second electrical resistivity in a direction perpendicular to the direction of height, the first electrical resistivity lower than the second electrical resistivity, such that the electron flow (218) moves primarily along the direction of height.

8. A light emitting diode (LED) assembly (400) comprising:
a semiconductor structure (204) comprising shaped (504, 604) layers of materials, wherein the shaped layers of material are configured to be formed on a substrate, shaped, and then removed (508, 610) from the substrate, the semiconductor structure (204) comprising:
a first semiconductor layer (206),
a second semiconductor layer (208), and
a light emitting layer (212) between the first semiconductor layer (206) and
the second semiconductor layer (208) for producing light responsive to passing current through the light emitting layer(212);
a first electrical contact (214) formed on a first circuitry substrate (316) and
bonded to a top surface of the semiconductor structure (204) to thereby form the first electrical contact (214) on top of the semiconductor structure (204);
a second electrical contact (216)on a bottom surface of the semiconductor structure (204), the second electrical contact being at least partially transparent;
the first circuitry substrate (316) having a first contact pad (318) connected to the first electrical contact (214); and
a second circuitry substrate (320) having a second contact pad (322) connected to the second electrical contact (216).

9. The LED assembly (400) of claim 8, wherein the semiconductor structure (204) has a mesa shape.

10. The LED assembly (400) of claim 8 or 9, wherein the second electrical contact (216) extends across the bottom surface of the semiconductor structure (204);
optionally, wherein the second electrical contact (216) is a transparent thin film conducting oxide.

11. The LED assembly (400) of any of claims 8 to 10, wherein the first electrical contact (214) is made of non-transparent metal.

12. The LED assembly (400) of any of claims 8 to 11, wherein the electrical resistivity of the material forming the first semiconductor layer (206) varies based on the direction of electron flow (218), wherein the first semiconductor layer has a first electrical resistivity along a direction of height and a second electrical resistivity in a direction perpendicular to the direction of height, the first electrical resistivity lower than the second electrical resistivity, such that the electron flow (218) moves primarily along the direction of height.

13. The LED assembly (400) of any of claims 8 to 12, wherein the bottom of the semiconductor structure (204) has a circular shape.

14. A light emitting diode (LED) assembly wafer comprising:
a plurality of LEDs, each LED (200) of the plurality of LEDs comprising:
a semiconductor structure (204) comprising shaped (504, 604) layers of materials, wherein the shaped layers of material are configured to be formed on a substrate, shaped, and then removed (508, 610) from the substrate, the semiconductor structure (204) comprising:
a first semiconductor layer (206),
a second semiconductor layer (208), and
a light emitting layer (212) between the first semiconductor layer (206) and
the second semiconductor layer (208) for producing light responsive to passing current through the light emitting layer;
a first electrical contact (214) formed on a first circuitry substrate (316) and
bonded to a top surface of the semiconductor structure (204) to thereby form the first electrical contact (214) on top of the semiconductor structure (204); and
a second electrical contact (216) on a bottom surface of the semiconductor structure (204), the second electrical contact (216) being at least partially transparent;
the first substrate (316) having first contacts pads (318), each of the first contact pads (318) connected to a respective one of the first electrical contacts (214) of the plurality of LEDs; and
a second substrate (320) having second contact pads (322), each of the second contact pads (322) connected to a respective one of the second electrical contacts (216) of the plurality of LEDs;
optionally, wherein the semiconductor structure (204) of each of the plurality of LEDs has a mesa shape.

## Patentansprüche

1. Ein Verfahren zum Herstellen einer Leuchtdiode (LED), wobei das Verfahren Folgendes beinhaltet:
Bilden (502, 602) von Materialschichten auf einem Substrat, wobei die Materialschichten eine erste Halbleiterschicht (206), eine zweite Halbleiterschicht (208) und eine lichtemittierende Schicht (212) zwischen der ersten und zweiten Halbleiterschicht (206, 208) zum Erzeugen von Licht als Antwort auf das Leiten von Strom durch die lichtemittierende Schicht (212) umfassen;
Formen (504, 604) der gebildeten Materialschichten zu mindestens einer Halbleiterstruktur (204);
Bilden (506, 606) eines ersten elektrischen Kontakts (214) auf einem ersten Schaltkreissubstrat (316) und Binden des ersten elektrischen Kontakts (214) auf dem ersten Schaltkreissubstrat (316) an eine Oberseite der Halbleiterstruktur (204), um den ersten elektrischen Kontakt (214) auf der Halbleiterstruktur (204) zu bilden;
Entfernen (508, 610) der Halbleiterstruktur (204) von dem Substrat;
Bilden (510, 612) eines zweiten elektrischen Kontakts (216) an einer Unterseite der Halbleiterstruktur (204), wobei der zweite elektrische Kontakt (216) mindestens teilweise transparent ist;
wobei der erste elektrische Kontakt (214) mit einer Kontaktstelle (318) auf dem ersten Schaltkreissubstrat (316) verbunden ist; und
Verbinden (514, 614) des zweiten elektrischen Kontakts (216) mit einer anderen Kontaktstelle (322) auf einem zweiten Schaltkreissubstrat (320).

2. Verfahren gemäß Anspruch 1, das ferner Folgendes beinhaltet:
Ausrichten der Halbleiterstruktur (204) auf das erste Schaltkreissubstrat (316); und
Ausrichten der Halbleiterstruktur (204) auf das zweite Schaltkreissubstrat (320).

3. Verfahren gemäß Anspruch 1 oder 2, wobei das zweite Schaltkreissubstrat (320) transparent ist.

4. Verfahren gemäß einem der Ansprüche 1 bis 3, wobei das Bilden (510, 612) des zweiten elektrischen Kontakts (216) an der Unterseite der Halbleiterstruktur (204) Folgendes beinhaltet:
Bilden des zweiten elektrischen Kontakts auf dem zweiten Schaltkreissubstrat (320); und
Binden des zweiten elektrischen Kontakts auf dem zweiten Schaltkreissubstrat (320) an die Unterseite der Halbleiterstruktur (204), um den zweiten elektrischen Kontakt (216) an der Unterseite der Halbleiterstruktur (204) zu bilden.

5. Verfahren gemäß einem der Ansprüche 1 bis 4, wobei der zweite elektrische Kontakt (216) ein transparentes leitfähiges Oxidmaterial beinhaltet;
wobei das Bilden (510, 612) des zweiten elektrischen Kontakts (216) an der Unterseite der Halbleiterstruktur (204) optional das Ablagern des transparenten leitfähigen Oxidmaterials als ein Dünnfilm auf der Unterseite der Halbleiterstruktur (204) beinhaltet.

6. Verfahren gemäß einem der Ansprüche 1 bis 5, wobei das Formen (504, 604) der gebildeten Materialschichten das Ätzen der Materialschichten zu einer Mesa (204) beinhaltet, wobei der erste elektrische Kontakt (214) auf einer Oberseite der Mesa (204) gebildet wird;
wobei die Materialschichten optional während des Formens (504, 604) der gebildeten Schichten durchgeätzt werden, um die mindestens eine Halbleiterstruktur (204) zu individuieren.

7. Verfahren gemäß einem der Ansprüche 1 bis 6, wobei die elektrische Resistivität des Materials, das die erste Halbleiterschicht (206) bildet, basierend auf der Richtung des Elektronenflusses (218) variiert, wobei die erste Halbleiterschicht (206) eine erste elektrische Resistivität entlang einer Höhenrichtung und eine zweite elektrische Resistivität in einer Richtung senkrecht zu der Höhenrichtung aufweist, wobei die erste elektrische Resistivität niedriger als die zweite elektrische Resistivität ist, sodass sich der Elektronenfluss (218) hauptsächlich entlang der Höhenrichtung bewegt.

8. Eine Leuchtdioden(LED)-Anordnung (400), die Folgendes beinhaltet:
eine Halbleiterstruktur (204), die geformte (504, 604) Materialschichten beinhaltet,
wobei die geformten Materialschichten konfiguriert sind, um auf einem Substrat gebildet, geformt und dann von dem Substrat entfernt (508, 610) zu werden, wobei die Halbleiterstruktur (204) Folgendes beinhaltet:
eine erste Halbleiterschicht (206),
eine zweite Halbleiterschicht (208) und
eine lichtemittierende Schicht (212) zwischen der ersten Halbleiterschicht (206) und der zweiten Halbleiterschicht (208) zum Erzeugen von Licht als Antwort auf das Leiten von Strom durch die lichtemittierende Schicht (212);
einen ersten elektrischen Kontakt (214), der auf einem ersten Schaltkreissubstrat (316) gebildet ist und an eine obere Fläche der Halbleiterstruktur (204) gebunden ist, um dadurch den ersten elektrischen Kontakt (214) auf der Halbleiterstruktur (204) zu bilden;
einen zweiten elektrischen Kontakt (216) auf einer unteren Fläche der Halbleiterstruktur (204), wobei der zweite elektrische Kontakt mindestens teilweise transparent ist;
wobei das erste Schaltkreissubstrat (316) eine erste Kontaktstelle (318) aufweist, die mit dem ersten elektrischen Kontakt (214) verbunden ist; und
wobei ein zweites Schaltkreissubstrat (320) eine zweite Kontaktstelle (322) aufweist,
die mit dem zweiten elektrischen Kontakt (216) verbunden ist.

9. LED-Anordnung (400) gemäß Anspruch 8, wobei die Halbleiterstruktur (204) eine Mesaform aufweist.

10. LED-Anordnung (400) gemäß Anspruch 8 oder 9, wobei sich der zweite elektrische Kontakt (216) über die untere Fläche der Halbleiterstruktur (204) erstreckt;
wobei der zweite elektrische Kontakt (216) optional ein leitendes transparentes Dünnfilmoxid ist.

11. LED-Anordnung (400) gemäß einem der Ansprüche 8 bis 10, wobei der erste elektrische Kontakt (214) aus nicht transparentem Metall gefertigt ist.

12. LED-Anordnung (400) gemäß einem der Ansprüche 8 bis 11, wobei die elektrische Resistivität des Materials, das die erste Halbleiterschicht (206) bildet, basierend auf der Richtung des Elektronenflusses (218) variiert, wobei die erste Halbleiterschicht eine erste elektrische Resistivität entlang einer Höhenrichtung und eine zweite elektrische Resistivität in einer Richtung senkrecht zu der Höhenrichtung aufweist, wobei die erste elektrische Resistivität niedriger als die zweite elektrische Resistivität ist, sodass sich der Elektronenfluss (218) hauptsächlich entlang der Höhenrichtung bewegt.

13. LED-Anordnung (400) gemäß einem der Ansprüche 8 bis 12, wobei die Unterseite der Halbleiterstruktur (204) eine kreisförmige Form aufweist.

14. Ein Leuchtdioden(LED)-Anordnungswafer, der Folgendes beinhaltet:
eine Vielzahl von LEDs, wobei jede LED (200) der Vielzahl von LEDs Folgendes beinhaltet:
eine Halbleiterstruktur (204), die geformte (504, 604) Materialschichten beinhaltet,
wobei die geformten Materialschichten konfiguriert sind, um auf einem Substrat gebildet, geformt und dann von dem Substrat entfernt (508, 610) zu werden, wobei die Halbleiterstruktur (204) Folgendes beinhaltet:
eine erste Halbleiterschicht (206),
eine zweite Halbleiterschicht (208) und
eine lichtemittierende Schicht (212) zwischen der ersten Halbleiterschicht (206) und der zweiten Halbleiterschicht (208) zum Erzeugen von Licht als Antwort auf das Leiten von Strom durch die lichtemittierende Schicht;
einen ersten elektrischen Kontakt (214), der auf einem ersten Schaltkreissubstrat (316) gebildet ist und an eine obere Fläche der Halbleiterstruktur (204) gebunden ist, um dadurch den ersten elektrischen Kontakt (214) auf der Halbleiterstruktur (204) zu bilden; und
einen zweiten elektrischen Kontakt (216) auf einer unteren Fläche der Halbleiterstruktur (204), wobei der zweite elektrische Kontakt (216) mindestens teilweise transparent ist;
wobei das erste Substrat (316) erste Kontaktstellen (318) aufweist, wobei jede der ersten Kontaktstellen (318) mit einem jeweiligen einen der ersten elektrischen Kontakte (214) der Vielzahl von LEDs verbunden ist; und
wobei ein zweites Substrat (320) zweite Kontaktstellen (322) aufweist, wobei jede der zweiten Kontaktstellen (322) mit einem jeweiligen einen der zweiten elektrischen Kontakte (216) der Vielzahl von LEDs verbunden ist; und
wobei die Halbleiterstruktur (204) jeder der Vielzahl von LEDs optional eine Mesaform aufweist.

## Revendications

1. Un procédé pour la fabrication d'une diode électroluminescente (DEL), le procédé comprenant :
la formation (502, 602) de couches de matériaux sur un substrat, les couches de matériaux incluant une première couche de semi-conducteur (206), une deuxième couche de semi-conducteur (208), et une couche électroluminescente (212) entre les première et deuxième couches de semi-conducteur (206, 208) pour la production de lumière en réponse au passage d'un courant à travers la couche électroluminescente (212) ;
la mise en forme (504, 604) des couches de matériau formées en au moins une structure de semi-conducteurs (204) ;
la formation (506, 606) d'un premier contact électrique (214) sur un premier substrat de circuiterie (316) et la liaison du premier contact électrique (214) sur le premier substrat de circuiterie (316) à un dessus de la structure de semi-conducteurs (204) pour former le premier contact électrique (214) sur le dessus de la structure de semi-conducteurs (204) ;
le retrait (508, 610) de la structure de semi-conducteurs (204) du substrat ;
la formation (510, 612) d'un deuxième contact électrique (216) au niveau d'un dessous de la structure de semi-conducteurs (204), le deuxième contact électrique (216) étant au moins partiellement transparent ;
le premier contact électrique (214) étant connecté à une plage de contact (318) sur le premier substrat de circuiterie (316) ; et
la connexion (514, 614) du deuxième contact électrique (216) à une autre plage de contact (322) sur un deuxième substrat de circuiterie (320).

2. Le procédé de la revendication 1, comprenant en outre :
l'alignement de la structure de semi-conducteurs (204) par rapport au premier substrat de circuiterie (316) ; et
l'alignement de la structure de semi-conducteurs (204) par rapport au deuxième substrat de circuiterie (320).

3. Le procédé de la revendication 1 ou de la revendication 2, dans lequel le deuxième substrat de circuiterie (320) est transparent.

4. Le procédé de n'importe lesquelles des revendications 1 à 3, dans lequel la formation (510, 612) du deuxième contact électrique (216) au niveau du dessous de la structure de semi-conducteurs (204) comprend :
la formation du deuxième contact électrique sur le deuxième substrat de circuiterie (320) ; et
la liaison du deuxième contact électrique sur le deuxième substrat de circuiterie (320) au dessous de la structure de semi-conducteurs (204) pour former le deuxième contact électrique (216) au niveau du dessous de la structure de semi-conducteurs (204).

5. Le procédé de n'importe lesquelles des revendications 1 à 4, dans lequel le deuxième contact électrique (216) comprend un matériau oxyde conducteur transparent ; facultativement, dans lequel la formation (510, 612) du deuxième contact électrique (216) au niveau du dessous de la structure de semi-conducteurs (204) comprend le dépôt du matériau oxyde conducteur transparent en un film mince sur le dessous de la structure de semi-conducteurs (204).

6. Le procédé de n'importe lesquelles des revendications 1 à 5, dans lequel la mise en forme (504, 604) des couches de matériau formées comprend la gravure des couches de matériaux en une mésa (204), le premier contact électrique (214) étant formé sur un dessus de la mésa (204) ;
facultativement, dans lequel les couches de matériau sont gravées sur toute leur épaisseur pendant la mise en forme (504, 604) des couches formées pour dégager l'au moins une structure de semi-conducteurs (204).

7. Le procédé de n'importe lesquelles des revendications 1 à 6, dans lequel la résistivité électrique du matériau formant la première couche de semi-conducteur (206) varie en fonction de la direction d'un flux électronique (218), la première couche de semi-conducteur (206) ayant une première résistivité électrique suivant une direction de hauteur et une deuxième résistivité électrique dans une direction perpendiculaire à la direction de hauteur, la première résistivité électrique étant inférieure à la deuxième résistivité électrique, de sorte que le flux électronique (218) se déplace principalement suivant la direction de hauteur.

8. Un assemblage de diodes électroluminescentes (DEL) (400) comprenant :
une structure de semi-conducteurs (204) comprenant des couches de matériaux mises en forme (504, 604), les couches de matériau mises en forme étant configurées pour être formées sur un substrat, mises en forme, et ensuite retirées (508, 610) du substrat,
la structure de semi-conducteurs (204) comprenant :
une première couche de semi-conducteur (206),
une deuxième couche de semi-conducteur (208), et
une couche électroluminescente (212) entre la première couche de semi-conducteur (206) et la deuxième couche de semi-conducteur (208) pour la production de lumière en réponse au passage d'un courant à travers la couche électroluminescente (212) ;
un premier contact électrique (214) formé sur un premier substrat de circuiterie (316) et
lié à une surface de dessus de la structure de semi-conducteurs (204) pour ainsi former le premier contact électrique (214) sur le dessus de la structure de semi-conducteurs (204) ;
un deuxième contact électrique (216) sur une surface de dessous de la structure de semi-conducteurs (204), le deuxième contact électrique étant au moins partiellement transparent ;
le premier substrat de circuiterie (316) ayant une première plage de contact (318) connectée au premier contact électrique (214) ; et
un deuxième substrat de circuiterie (320) ayant une deuxième plage de contact (322) connectée au deuxième contact électrique (216).

9. L'assemblage de DEL (400) de la revendication 8, dans lequel la structure de semi-conducteurs (204) a une forme de mésa.

10. L'assemblage de DEL (400) de la revendication 8 ou de la revendication 9, dans lequel
le deuxième contact électrique (216) s'étend sur toute la surface de dessous de la structure de semi-conducteurs (204) ;
facultativement, dans lequel le deuxième contact électrique (216) est un oxyde conducteur en film mince transparent.

11. L'assemblage de DEL (400) de n'importe lesquelles des revendications 8 à 10, dans lequel le premier contact électrique (214) est constitué de métal non transparent.

12. L'assemblage de DEL (400) de n'importe lesquelles des revendications 8 à 11, dans lequel la résistivité électrique du matériau formant la première couche de semi-conducteur (206) varie en fonction de la direction d'un flux électronique (218), la première couche de semi-conducteur ayant une première résistivité électrique suivant une direction de hauteur et une deuxième résistivité électrique dans une direction perpendiculaire à la direction de hauteur, la première résistivité électrique étant inférieure à la deuxième résistivité électrique, de sorte que le flux électronique (218) se déplace principalement suivant la direction de hauteur.

13. L'assemblage de DEL (400) de n'importe lesquelles des revendications 8 à 12, dans lequel le dessous de la structure de semi-conducteurs (204) a une forme circulaire.

14. Une plaquette d'assemblage de diodes électroluminescentes (DEL) comprenant :
une pluralité de DEL, chaque DEL (200) de la pluralité de DEL comprenant :
une structure de semi-conducteurs (204) comprenant des couches de matériaux mises en forme (504, 604), les couches de matériau mises en forme étant configurées pour être formées sur un substrat, mises en forme, et ensuite retirées (508, 610) du substrat,
la structure de semi-conducteurs (204) comprenant :
une première couche de semi-conducteur (206),
une deuxième couche de semi-conducteur (208), et
une couche électroluminescente (212) entre la première couche de semi-conducteur (206) et la deuxième couche de semi-conducteur (208) pour la production de lumière en réponse au passage d'un courant à travers la couche électroluminescente ;
un premier contact électrique (214) formé sur un premier substrat de circuiterie (316) et
lié à une surface de dessus de la structure de semi-conducteurs (204) pour ainsi former le premier contact électrique (214) sur le dessus de la structure de semi-conducteurs (204) ; et
un deuxième contact électrique (216) sur une surface de dessous de la structure de semi-conducteurs (204), le deuxième contact électrique (216) étant au moins partiellement transparent ;
le premier substrat (316) ayant des premières plages de contact (318), chacune des premières plages de contact (318) étant connectée à un premier contact électrique respectif parmi les premiers contacts électriques (214) de la pluralité de DEL ; et
un deuxième substrat de circuiterie (320) ayant des deuxièmes plages de contact (322),
chacune des deuxièmes plages de contact (322) étant connectée à un deuxième contact électrique respectif parmi les deuxièmes contacts électriques (216) de la pluralité de DEL ;
facultativement, dans laquelle la structure de semi-conducteurs (204) de chaque DEL de la pluralité de DEL a une forme de mésa.
